(19) Europäisches Patentamt
European Patent Office
Office européen des brevets

(11) **EP 4 472 079 A1**

(12) **EUROPEAN PATENT APPLICATION**

(43) Date of publication:
**04.12.2024 Bulletin 2024/49**

(21) Application number: **23176446.5**

(22) Date of filing: **31.05.2023**

(51) International Patent Classification (IPC):
**H03L 7/093** *(2006.01)*    **H03L 7/197** *(2006.01)*

(52) Cooperative Patent Classification (CPC):
**H03L 7/1974; H03L 7/093; H03L 7/1976;**
H03L 2207/50

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ETH Zurich
8092 Zurich (CH)**

(72) Inventors:
• **BURGER, Thomas Uli
5452 Oberrohrdorf (CH)**
• **DAVAMI, Parham
8600 Dübendorf (CH)**

(74) Representative: **P&TS SA (AG, Ltd.)**
**Avenue J.-J. Rousseau 4**
**P.O. Box 2848**
**2001 Neuchâtel (CH)**

(54) **A DIGITAL FRACTIONAL-N PHASE LOCK LOOP**

(57)    The present invention relates to a digital fractional-N phase lock loop (PLL) (1), comprising:
- a forward path comprising a phase detector (4), a digital loop filter (3), a digitally-controlled oscillator (2);
- a feedback path comprising a feedback element (5, 6), wherein a phase detector output of the phase detector (4) is connected to a loop filter input of the digital loop filter (3) for providing an unfiltered control signal ($S_{uf}$), and a loop filter output of the digital loop filter (3) is connected to an oscillator input of the digitally-controlled oscillator (2) for providing a filtered control signal (Sf), wherein the unfiltered control signal ($S_{uf}$) and the filtered control signal (Sf) each contain a periodic error signal having a mutually different amplitude;
- a digital-to-time converter (7), arranged in the forward or the feedback path and connected with a converter output to a phase detector input of the phase detector (4);
- a spur compensation unit (10) arranged with two inputs and an output, wherein a first input is provided to receive the unfiltered control signal ($S_{uf}$) and a second input is configured to receive the filtered control signal (Sf), wherein the spur compensation unit (10) is provided to determine a compensation signal ($S_{scop}$) along a fractional phase instance of operation of the digital fractional-N PLL (1), and wherein the spur compensation unit (10) is further arranged to output the said compensation signal ($S_{scop}$) to a converter input of the digital-to-time converter (7) or wherein the spur compensation unit (10) is further provided to inject the said compensation signal ($S_{scop}$) into the unfiltered control signal ($S_{uf}$) for compensation the periodic error signal.

Fig. 3b

**Description**

**Technical domain**

The present invention concerns a digital fractional-N phase lock loop (PLL). The PLL is enabled, inter alia, to output an AC signal with high spectral purity.

**Related art**

Frequency synthesis is an engineering field that involves generating different signal frequencies from a single reference or time base. Typically, a Voltage Controlled Crystal Oscillator (VCXO), a Digitally Controlled Crystal Oscillator (DCXO), or even a Temperature Compensated Crystal Oscillator (TCXO) is used as the time base, providing a stable and low phase noise reference frequency for the synthesizer circuit. One of the most widely used techniques in frequency synthesis is the phase lock loop (PLL) circuit, which utilizes negative feedback to perform frequency multiplication and to generate output frequencies based on the reference frequency and output frequency division or timing generation. In the following the term PLL circuit or PLL refers to a digital PLL circuit or all-digital PLL circuits.

The PLL circuit employs an oscillator at reference frequency as described above to tune a digitally-controlled oscillator (DCO) and achieve a "locked state", in which the output frequency equals the desired frequency multiplied by an integer number N (integer-N PLL). Changing the value of N allows the DCO to be tuned across the frequency band of interest, with the minimum frequency resolution or channel spacing being equal to the reference frequency. Fractional-N PLL takes this concept further, enabling a frequency resolution that is a fractional portion of the reference frequency. This is achieved by dynamically changing divider values in the feedback loop resulting in an "average" division that becomes a fraction. While there is no device that can divide by a fraction, the principle of fractionality is achieved through averaging. Recent advancements in the field have allowed for the integration of a frequency-locked loop into the loop circuit, eliminating the need for a divider in the feedback loop.

Fractional-N PLLs offer better frequency resolution, larger loop bandwidth, and possibly lower phase noise compared to integer-N PLLs, making them ideal for high-performance applications in various technical fields.

Dynamically changing the divider values in the feedback loop creates unwanted spurious signals in the output frequency spectrum. These signals are commonly referred to as "fractional spurs" as their frequencies are multiples of the frequency defined by the desired fractional part of the reference frequency used in the PLL. In general, fractional spurs only exist when the fractional numerator is nonzero. Such fractional spurs are most severe when they fall into the loop filter bandwidth as in this case they are not attenuated by the latter. Various factors can contribute to the appearance of such spurs. The primary culprits are fractional noise, which can be mitigated through a divider switching sequence generated by a delta-sigma modulator that reduces in-band quantization noise and employs the loop filter to supress the out-of-band quantization noise , and crosstalk onto the DCO that is not addressed by the loop filter.

One of the primary methods for reducing fractional spurs is to utilize a digital-to-time converter (DTC). This converter can be situated in the feedback loop either immediately following the divider or between the reference oscillator and the phase detector input. Essentially, the DTC is a circuit capable of producing a programmable time delay that can be adjusted using a digital code. This effectively eliminates the periodic signal associated with the fractional numerator. Real-life DTC implementations exhibit several imperfections. These imperfections often include limited resolution, random noise generation, range mismatch, and non-linear behaviour, especially in response to temperature fluctuations or changes in the voltage supply. These drawbacks can restrict the suppression of fractional spurs in operation.

Several solutions have been suggested in the literature to address the drawbacks arising from imperfections of the DTCs. One such solution, proposed by P. Chen, et al., "Fractional Spur Suppression in All-Digital Phase-Locked Loops", 2015 IEEE International Symposium on Circuits and Systems (ISCAS), May 2015, involves calibrating the gain of the DTC to compensate for the associated quantisation error. However, the calibration of DTC gain just adjusts the DTC range to match the period corresponding to the desired output frequency, but it doesn't compensate for the nonlinearity in the DTC transfer function which requires more elaborate processing.

Furthermore, the suppression of fractional spurs is not entirely effective, and reducing the spur level to an acceptable degree requires a relatively high computational effort. Other solutions known from prior art offer enhanced spurious noise reduction, but these solutions can degrade the main PLL performance, such as the loop stability or the frequency settling time.

**Short disclosure of the invention**

An aim of the present invention is the provision of a digital fractional-N PLL with the objective of overcoming the shortcomings and limitations of the state of the art.

A further aim is the provision of a digital fractional-N PLL configured for providing an output AC signal containing low amplitudes of fractional spurs.

An auxiliary aim is the provision of a digital fractional-N PLL configured to enable a flexible calibration for compensating fractional spurs.

A further auxiliary aim is the provision of a digital fractional-N PLL with a flexible calibration for fractional spur compensation that can run in the back ground (online) during operation of the main PLL.

A further auxiliary aim is the provision of a digital fractional-N PLL that outputs an AC signal with high spectral purity, fast frequency settling time, and can be provided with a high frequency resolution.

According to the main aspect of the present invention, a digital fractional-N PLL involving the features recited in claim 1 is disclosed. Further features and embodiments of the digital fractional-N PLL of the present invention are described in the dependent claims.

The invention relates to the digital fractional-N PLL, comprising:

- a forward path comprising a phase detector, a digital loop filter, a digitally-controlled oscillator;
- a feedback path comprising a feedback element, wherein a phase detector output of the phase detector is connected to a loop filter input of the digital loop filter for providing an unfiltered control signal, and a loop filter output of the digital loop filter is connected to an oscillator input of the digitally-controlled oscillator for providing a filtered control signal, wherein the unfiltered control signal and the filtered control signal each contain a periodic error signal having a mutually different amplitude;
- a digital-to-time converter, arranged in the forward or the feedback path and connected with a converter output to a phase detector input of the phase detector;
- a spur compensation unit arranged with two inputs and an output, wherein a first input is provided to receive the unfiltered control signal and a second input is configured to receive the filtered control signal, wherein the spur compensation unit is provided to determine a compensation signal along a fractional phase instance of operation of the digital fractional-N PLL, and wherein the spur compensation unit is further arranged to output the said compensation signal to a converter input of the digital-to-time converter or wherein the spur compensation unit is further provided to inject the said compensation signal into the unfiltered control signal for compensating the periodic error signal.

The digital fractional-N PLL building blocks not explicitly indicated as digital can be analog or at least semi-analog. However, the digital fractional-N PLL can also be embodied as an all-digital PLL, with all building blocks defined as digital at the input/output level. The digital building blocks of the digital fractional-N PLL circuit can be implemented using digital CMOS technology. All building blocks may operate clocked, taking the reference signal and as a clock signal. For some digital building blocks, it can be useful to take the output AC signal as a clock signal due to the higher frequency, which may be required when oversampling is required.

The digital fractional-N PLL can be used in communication devices such as transceivers for wireless or wireline applications, in test and measurement devices, such as medical devices (e.g. MRI systems), oscilloscopes, spectrum analyzers, etc., whereby the list is not exhaustive. However, this shall not exclude the use of the digital fractional-N PLL in any other application where the generation of a stable clock or carrier signal is required.

The phase detector can be configured as a digital vernier phase detector, a bang-bang phase detector, a sampling phase detector, or a time-to-digital converter, whereby the list is not final.

The forward path can be defined as the path that carries the reference signal to the phase detector and then to the digital loop filter and finally to the digitally-controlled oscillator, whereby the feedback path can refer to the path that carries a portion of the output AC signal generated by the digitally-controlled oscillator back to the input of the digital fractional-N PLL to compare it with the reference signal. The feedback element can be a variable divider for the division of the output AC signal, comprised in the feedback path or a phase interpolator, e.g. in the form of a retimer circuit, in case the digital fractional-N PLL is configured as divider-less digital fractional-N PLL.

The digital loop filter can be configured as an nth-order digital IIR loop filter or any other sort of digital filter that can provide the characteristics of a digital low-pass filter. The phase detector at its output can provide the unfiltered control signal, which may contain noise and distortion, such as electrical and quantization noise and deterministic distortion, generated by non-idealities of the phase detector, the digital-to-time converter and further building blocks of the digital fractional-N PLL. The unfiltered control signal can digitally represent an AC signal and may contain a DC offset. The digital loop filter filters the unfiltered control signal to obtain a filtered control signal that can be used to control the frequency of the output AC signal of the digitally-controlled oscillator. The filtered control signal can be a digital representation of a DC signal. The unfiltered and filtered control signals may contain a periodic error signal that can originate from the non-idealities of the phase detector or the combination of the phase detector and the digital-to-time converter. The amplitude of the periodic error signal varies in the mentioned control signals, since the digital loop filter supports filtering the periodic error signal, which may reduce the amplitude.

The frequency control word can be a digital representation of a fixed-point number and may be used by the feedback element to set the feedback division ratio. The frequency control word can be comprised of an integer and a fractional part.

The fractional phase instance of operation can relate to the operating points in which the digital fractional-N PLL, particularly the phase detector, the digital-to-time converter and/or the feedback element, operates on the fractional part of the accumulated frequency control word. The length of the fractional phase instance may vary depending on the resolution, in particular the bit length of the fractional phase instance can equal the bit length of the fractional code word.

The spur compensation unit can be provided to output the compensation signal to the digital-to-time converter in the form of a digital signal, such as a multibit signal, which can be used by the digital-to-time converter for calibration or as an addition for the frequency control word used by the digital-to-time converter to set the time delay/phase shift. In summary, the digital signal can either correct the operation of the digital-to-time converter directly or just correct the input code to the digital-to-time converter.

In conclusion, the spur compensation unit enables the digital fractional-N PLL to provide an output AC signal of high purity by suppression, i.a., the periodic error signal, which may manifest in spurious signals comprised in the output AC signal. The advantage of the spur compensation unit is that not only the periodic error signal before the digital loop filter is included in the compensation of the periodic error signal but also portions of the periodic error signal that are not reduced by the digital loop filter. Thus the operational behavior of the entire control loop is included in the compensation, which can result in an improved reduction of the periodic error signal and, finally, in a reduction of the spurs or fractional spurs, respectively.

The spur compensation unit can further be used to calibrate the digital-to-time converter, while the digital fractional-N PLL is operated by directly outputting the signal for compensation to the digital-to-time converter and thereby performing online calibration. This can be advantageous over offline-calibration methods disclosed in the literature. The spur compensation unit can be a building block that can be operated alongside the main digital fractional-N PLL circuit and not part of the said main circuit, thereby functioning as an auxiliary building block. This advantage can be driven further if the spur compensation unit directly injects the compensation signal into the unfiltered control signal. In this case, the spur compensation unit and hence the PLL can be recalibrated while the spur compensation unit injects the compensation signal into the unfiltered control signal. Thus the operation of the digital fractional-N PLL can be continued uninterrupted.

Alternatively, or in addition, the spur compensation unit may supply the compensation signal to the converter input of the digital-to-time converter, and the compensation signal may also be injected into the unfiltered control signal simultaneously or alternating. Providing the compensation signal to the digital-to-time converter can be useful, as indicated before, such as for the calibration of the said converter, whereby portions of the periodic error signal that are not compensated by the calibration of the digital-to-time converter may be suppressed or compensated by the signal that is injected into the unfiltered control signal.

In a first embodiment of the main aspect, the feedback element can be configured as a fractional divider or a re-timer circuit and wherein the phase detector can be provided as a time-to-digital converter, in particular as a multi- or single-bit time-to-digital converter. The fractional divider may be used for the digital fractional-N PLL in a divider-based configuration, whereby the re-timer circuit may be used for the digital fractional-N PLL in a divider-less configuration.

In a second embodiment of the main aspect, the spur compensation unit can comprise a pre-processing stage, configured with a digital high-pass filter, a digital integrator and a proportional gain arranged in series, wherein the spur compensation unit can be adapted to pass the filtered control signal through the pre-processing stage and can be provided to sum the passed filtered control signal with the unfiltered control signal by means of an adder for providing a pre-processed control signal at a pre-processing stage output. The digital high-pass filter, the digital integrator, and the proportional gain may be arranged in series in the order as stated, whereby the input of the digital high-pass filter can be operatively connected to the output of the digital loop filter. The digital high-pass filter can also be configured as nth-order digital IIR filter. However, the order may be lower compared to the order of the digital IIR loop filter. Alternatively, a less sophisticated filter design for the digital high-pass filter might be chosen, as the main objective of the high-pass filter is to remove the DC component contained in the filtered control signal. The pre-processed control signal can also be referred to as a prefiltered control signal.

In a third embodiment of the main aspect, the spur compensation unit can further comprise a time-interleaved low-pass filter configured with a low-pass filter input and output, wherein the low-pass filter input can be connected to the pre-processing stage output and the low-pass filter output can be engaged with the connection between the phase detector output and the loop filter input to inject the said compensation signal into the unfiltered control signal for compensation the periodic error signal. The term engaged can relate to the circumstance that the low-pass filter output can be operatively connected to the connection between the phase detector output and the loop filter input. Time-interleaved filters, such as the time-interleaved low-pass filter, is a type of filter that can use multiple filter channels in parallel, with each channel processing a portion of the input signal. The filter channels can be identically configured; however, it is also possible to configure some or all filter channels mutually differently. The output of each channel can then be time-interleaved to generate the final filtered output signal for compensation of the periodic error signal. The basic idea of the time-interleaved low-pass filter can be to lower the sampling rate of the individual channel and to create a frequency repetive transfer function while maintaining a reasonable cost and complexity.

In a further embodiment of the main aspect, the connection between the phase detector output and the loop filter input can comprise an injection point for injecting the compensation signal into the unfiltered control signal and a tap point for connecting the first input of the spur compensation unit to the connection, wherein the injection point can be situated between the loop filter input and the tap point. As indicated, the compensation signal can be supplied by the spur compensation unit and injected into the unfiltered control signal if the spur compensation unit is provided to do so.

In a different embodiment of the main aspect, the spur compensation unit can further comprise a time-interleaved integrator configured with an integrator input and an integrator output, wherein the integrator input is connected to the pre-processing stage output and the integrator output is engaged with the connection between the phase detector output and the loop filter input to inject the said compensation signal into the unfiltered control signal or the integrator output is connected to the converter input of the digital-to-time converter for compensation the periodic error signal. Instead of having a time-interleaved low-pass filter, it may also be possible to have a time-interleaved integrator. Also, the time-interleaved integrator may have different channels, equally, partly equal, or mutually different configurated. The latter two possibilities, however, may lead to increased complexity and additional computational effort, which may not be desirable. The explanation as for the time-interleaved low-pass filter may apply accordingly.

In another embodiment of the main aspect, the connection between the phase detector output and the loop filter input can comprise an injection point for injecting the compensation signal into the unfiltered control signal and a tap point for connecting the first input of the spur compensation unit to the connection, wherein the tap point can be situated between the loop filter input and the injection point. The injection point can be provided in the form of a summing point.

In a further embodiment of the main aspect, the time-interleaved low-pass filter, or the time-interleaved integrator, can comprise a demultiplexer stage configured with two demultiplexer inputs and a number of demultiplexer outputs, wherein a first demultiplexer input can be configured to receive the pre-processed control signal and a second demultiplexer input can be configured to receive a fractional part of an accumulated frequency control word signal, wherein the demultiplexer stage can be arranged to output the pre-processed control signal to different demultiplexer outputs dependent on a value of the fractional part of the accumulated frequency control word signal. The fractional part of the frequency control word signal can be accumulated using an accumulator to obtain the accumulated frequency control word signal. Alternatively, the frequency control word signal can be accumulated using an accumulator, and only the fractional part of the accumulated frequency control word signal may be considered. The value of the accumulated frequency control word can be used to select the output of the demultiplexer, which in return can set the channel of the time-interleaved low-pass filter or the time-interleaved integrator, as explained before.

In another embodiment of the main aspect, when configured as the time-interleaved low-pass filter, the time-interleaved low-pass filter can comprise a midpoint pinning stage provided with a number of midpoint pinning stage outputs and can be configured with a number of low-pass filters, wherein each low-pass filter can be connected at a low-pass filter input to one demultiplexer output. The aim of the midpoint pinning stage can be, to reference each low-pass filter output to a reference value. The pre-processed control signal inputted into the one demultiplexer input may have a DC offset. This offset can be eliminated or at least significantly reduced by referencing the low-pass filter output to a predefined reference or a predefined threshold. Preferably the reference value is zero, but a different value might be used when required for the design.

In a further embodiment of the main aspect, when configured as the time-interleaved integrator, the time-interleaved integrator can comprise a midpoint pinning stage provided with a number of midpoint pinning stage outputs and can be configured with a number of integrators, wherein each integrator can be connected at an integrator input to one demultiplexer output. The explanation concerning the aim of the midpoint pinning stage applies correspondingly.

In a different embodiment of the main aspect, when configured as the time-interleaved low-pass filter, each low-pass filter can be configured with a low-pass filter output, or when configured as the time-interleaved integrator, each integrator can be provided with an integrator output, wherein the midpoint pinning stage can be provided to reference each low-pass filter output or each integrator output to a reference threshold respectively.

In a further embodiment of the main aspect, the midpoint pinning stage can comprise an averaging stage configured with a number of averaging stage inputs and an averaging stage output, wherein every averaging stage input can be connected to a low-pass filter output (when configured as the time-interleaved low-pass filter) or an integrator output (when configured as the time-interleaved integrator), wherein the averaging stage can be configured to determine an average from output signals outputted at the low-pass filter outputs or integrator outputs, wherein the averaging stage output can be engaged with midpoint pinning stage outputs for subtracting the determined average from the output signals outputted at the low-pass filter outputs or integrator outputs. The averaging stage can be an alternative means to pinning the low-pass filter outputs or integrator outputs to the reference.

In another embodiment of the main aspect, the time-interleaved low-pass filter, or the time-interleaved integrator, can comprise a multiplexer stage configured with a number of multiplexer inputs and a multiplexer output, wherein each multiplexer input of a first number of multiplexer inputs can be connected to a midpoint pinning stage output and wherein one multiplexer input of a second number of multiplexer inputs can be configured to receive the accumulated frequency control word signal, wherein the multiplexer stage can be arranged to connect a different midpoint pinning stage output to the multiplexer output dependent on a value of the fractional part of the accumulated frequency control word signal for providing the compensation signal at the multiplexer output. The multiplexer output can then be connected to the digital-to-time converter input or to the injection point.

In a different embodiment of the main aspect, the time-interleaved low-pass filter, or the time-interleaved integrator can comprise an interpolation/extrapolation unit configured with a number of inputs and outputs, wherein each input can be connected to a midpoint pinning stage output, wherein the time-interleaved low-pass filter can be configured to interpolate or extrapolate between signals outputted at the midpoint pinning stage outputs. The interpolation of the output signals outputted at the midpoint pinning stage can be useful as the fractional part of the accumulated frequency control word may have a finer resolution than the digital code controlling the time-interleaved filter. Therefore interpolation between the output values of the midpoint pinning stage corresponding to the additional bits in the accumulated frequency control word not represented in the time-interleaved filter, such as e.g. linear interpolation, can lead to lower fractional spurs in the AC output signal of the PLL as compared to not using interpolation.

In a further embodiment of the main aspect, the time-interleaved low-pass filter, or the time-interleaved integrator can comprise a multiplexer stage configured with a number of multiplexer inputs and a multiplexer output, wherein each multiplexer input of a first number of multiplexer inputs can be connected to an output of the interpolation/extrapolation unit and wherein one multiplexer input of a second number of multiplexer inputs can be configured to receive the accumulated frequency control word signal, wherein the multiplexer stage can be arranged to connect a different output of the interpolation/extrapolation unit to the multiplexer output dependent on a value of the fractional part of the accumulated frequency control word signal for providing the compensation signal at the multiplexer output.

Even though the individual embodiments of the main aspect cover different aspects of the invention, some or all embodiments can be combined when it is useful and feasible from a technical standpoint.

According to a side aspect of the present invention, a device for magnetometry in magnetic resonance imaging is concerned. The device comprises the digital fractional-N PLL of the main aspect (including any embodiment or a combination thereof), wherein the digital fractional-N PLL is configured to selectively output an AC signal that can be divided to an application frequency of approximately 60, 120, 280, or 440 MHz. The said AC signal can be used as an input signal for the transmitter or receiver path of the device.

The digital fractional-N PLL enables the device to use an arbitrary application frequency with kHz resolution which is important in the field of magnetic resonance imaging as the systems are built on proprietary specifications where the required application frequencies varies between manufacturers.

The digital fractional-N PLL also allows to settle faster to the desired frequency than a corresponding integer-N PLL due to the larger loop bandwidth which results in a lower power consumption when operated in a duty-cycled fashion.

The spur compensation/calibration feature enables the measurement receiver operated by the digital fractional-N PLL to measure a signal only limited by noise which can be reduced by filtering and bandwidth reduction and not disturbed by a periodic signal such as a fractional spur which usually cannot be eliminated by simple techniques such as filtering.

**Short description of the drawings**

Exemplar embodiments of the invention are disclosed in the description and illustrated by the drawings in which:

Fig. 1a illustrates a divider-based digital PLL architecture according to the prior art schematically.

Fig1b illustrates a divider-less digital PLL architecture according to the prior art schematically.

Figs. 2a, 2b show variants of spur compensation arrangements for the PLL of **Fig. 1a or 1b** known from the prior art in block diagrams.

Figs. 3a-3c illustrate variants of a digital PLL architecture, including the spur compensation unit according to the invention.

Figs. 4a-4c show variants of the spur compensation unit in greater detail.

Figs. 5a, 5b illustrate block diagrams of the digital PLL configured with a spur compensation unit, including a non-ideality injected into the loop.

Fig. 6 shows simulation results of the noise floor of a digital PLL with and without the spur compensation unit.

EP 4 472 079 A1

**Examples of embodiments of the present invention**

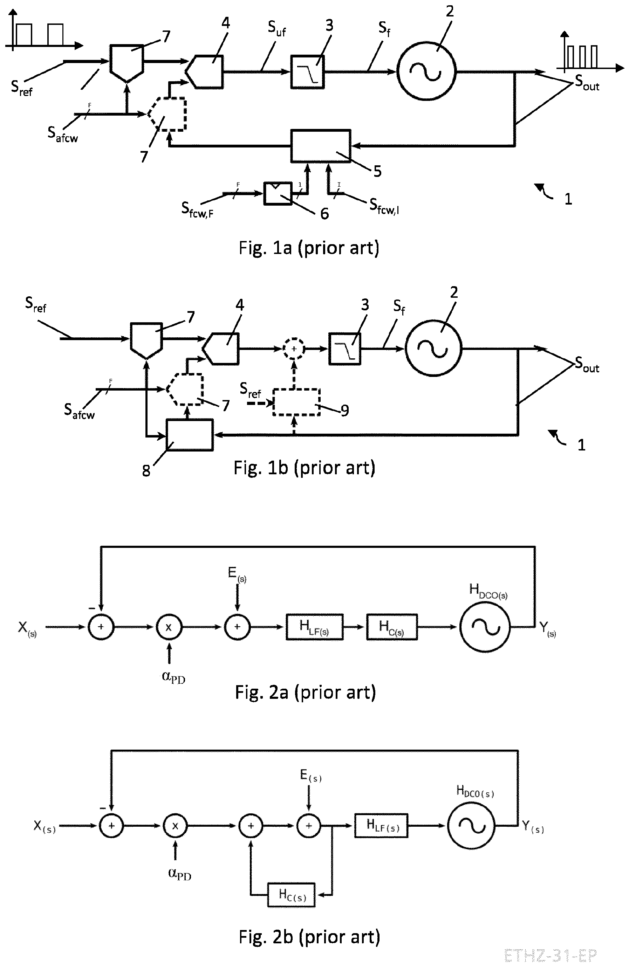

Fig. 1a illustrates a digital fractional-N PLL, in short, digital PLL, architecture according to the prior art schematically. The digital PLL 1 comprises a digital-to-time converter 7 that can be either situated in the forward path and thereby receiving the reference AC signal $S_{ref}$ or in the feedback path and thereby receiving the feedback signal originating from the feedback element, which is in the present illustrating example a frequency divider 5, configured as a dual modulus divider, engaged with a delta-sigma modulator 6. Suppose the digital-to-time converter 7 is situated in the forward path, it can delay the reference AC signal $S_{ref}$ in dependency on the fractional part of the accumulated frequency control word signal $S_{afcw}$. The digital-to-time converter 7 outputs the reference AC signal $S_{ref}$ to the first input of the phase detector 4, in this example configured as time-to-digital converter, where the reference AC signal $S_{ref}$ is compared to the feedback signal inputted at the second input of the phase detector 4.

Alternatively, suppose the digital-to-time converter 7 is situated in the feedback path, it can delay the feedback signal in dependency on the fractional part of the accumulated frequency control word signal $S_{afcw}$. The digital-to-time converter 7 outputs the feedback signal to the second input of the phase detector 4, where the feedback signal is compared to the reference AC signal $S_{ref}$ inputted at the first input of the phase detector 4. The frequency control word signal $S_{fcw}$ as such is a digital representation of a fixed-point number, where the integer part $S_{fcw,I}$ sets the integer divisional factor of the frequency divider 5 and the fractional part $S_{fcw,F}$ sets the fractional division factor of the frequency divider 5 in concert with the delta-sigma modulator 6. The phase detector 4, outputs the unfiltered phase detector output signal $S_{uf}$ in dependency of the phase difference (or time difference) of the two input signals. The unfiltered phase detector output signal $S_{uf}$ is a digital signal, in the form of a multibit signal, which can comprise an AC component and a DC offset, whereby the unfiltered phase detector output signal $S_{uf}$ is inputted into the digital low-pass filter 3 functioning as the loop filter. The digital low-pass filter 3 smooths the unfiltered phase detector output signal $S_{uf}$ for providing a filtered phase detector output signal Sf. The filtered phase detector output signal St, in the form of the multibit signal, is inputted into the digitally controlled oscillator 2, which sets the frequency of the output AC signal $S_{out}$ in dependency on the filtered phase detector output signal Sf. As it can be noticed in Fig. 1a, the frequency of the reference AC signal $S_{ref}$ is lower than the frequency of the output AC signal $S_{out}$.

When the digital PLL 1 is operating in fractional mode, the frequency divider 5 is set to a variable value that, on average, yields a desired non-integer division ratio. It is known to use the delta-sigma modulator 6 to control frequency divider 5 in this manner and achieve a fine frequency resolution at the frequency divider output by means of oversampling to interpolate fractional frequency with a coarse dual modulus divider. A disadvantage of this approach is that it introduces large quantization errors at the input of the time-to-digital converter 4. These quantization errors can be reduced by digital-to-time converter 7, as it can either variably delay the reference AC signal $S_{ref}$ inputted at the first input of the time-to-digital converter 4 (when situated in the forward path), or variably delay the feedback signal inputted at the second input of the time-to-digital converter 4 (when situated in the feedback path). Under various operational conditions, however, the time-to-digital converter 4, the digital-to-time converter 7, or the combination of both influencing each other, behave non-ideal. Non-idealities by design, random fabrication device mismatch combined with changing operating conditions such as electrical noise, temperature variations, aging, EMC, fluctuations in the supply line, etc. may lead to a non-ideal behaviour of the circuit elements. Any non-ideality in the circuit elements can result in a gain error or higher order non-linearities in the digital -to-time converter 7 can result in imperfect cancellation of the accumulated fractional time/phase and to a compensation error after conversion by the time-to-digital converter 4 finally leading to fractional spurs. In general, any non-ideality in the feedback and/or feedforward paths comprising divider, digital-to-time and time-to-digital converters may lead to unwanted spurs and noise.

Fig. 1b illustrates an example of an alternative implementation of the digital PLL 1 architecture of Fig. 1a according to the prior art. The digitally controlled oscillator 2, the digital low-pass filter 3, the time-to-digital converter 4, and the digital-to-time converter 7 can be equally configured or situated in the loop architecture as shown in Fig. 1a. However, the loop architecture lacks the combination of the frequency divider 5 and the delta-sigma modulator 6, which is replaced by the re-timer circuit 8, which optionally operates in concert with the frequency-locked-loop 9. The re-timer circuit 8 and the optional frequency-locked-loop 9 function as an alternative feedback element, whereby the circuit architecture illustrates a divider-less fractional digital PLL. The re-timer circuit 8 functions as a simple selector to select the correct edge of output AC signal $S_{out}$ for feedback. Its output is the first edge of the output AC signal $S_{out}$ after reference AC signal $S_{ref}$. The frequency-locked-loop 9 can be added to ensure the correct frequency locking. In the locking state of the digital PLL 1, the output of the frequency-locked-loop 9 is always constant. The frequency-locked-loop 9 may be implemented differently, as known from the prior art, independent from the main digital PLL architecture. Even in the present divider-less fractional digital PLL architecture, the digital-to-time converter 7 is required, as the principle for generating spurs is precisely the same as for the divider-based digital PLL (Fig. 1a) architecture. The digital-to-time converter 7 can be flexibly situated in the forward or feedback path.

Besides the possibility of calibration of the digital-to-time converter 7 and/or the time-to-digital converter 4 for reducing the impact of non-idealities under various operational conditions, techniques are known from the prior art to suppress spurious signals by using filter elements. Figs. 2a and 2b show variants of spur compensation arrangements for the PLL of Fig. 1a or Fig. 1b using filter elements known from the prior art in block diagrams.

The closed-loop transfer function of the in Fig. 2a illustrated block diagram can be presented as:

$$Y(s) = \frac{\mathbf{H_C(s)} \cdot \alpha_{PD} \cdot H_{LF}(s) \cdot H_{DCO}(s)}{1 + \mathbf{H_C(s)} \cdot \alpha_{PD} \cdot H_{LF}(s) \cdot H_{DCO}(s)} X(s)$$

$$+ \frac{\mathbf{H_C(s)} \cdot H_{LF}(s) \cdot H_{DCO}(s)}{1 + \mathbf{H_C(s)} \cdot \alpha_{PD} \cdot H_{LF}(s) \cdot H_{DCO}(s)} E(s),$$

(1)

where:

X(s) denotes the input phase / reference oscillator phase;
Y(s) denotes the output / PLL oscillator phase;
E(s) denotes a non-ideality or disturbance injected into the forward path;
Hc(s) denotes the transfer function of the compensating filter element, in particular of a digital filter element in the forward path;
$H_{DCO(S)}$ denotes the transfer function of the digitally controlled oscillator 2;
$H_{LF(S)}$ denotes the transfer function digital loop filter (digital low-pass);
$\alpha_{PD}$ denotes the proportional signal time-to-digital converter 4.

The order of the filter element and the digital loop filter in the forward path can be swapped, whereby equation (1) applies correspondingly.

By considering equation (1), one can notice that by adding the filter element, the poles of the filter loop are affected. In order to reduce the error signal E(s), $|H_c(s)|$ needs to be much smaller than 1, which can shift the poles of Y(s) to higher frequencies leading to instability. By adding the filter element, the performance of the filter, especially for frequency settling time in response to a new frequency setpoint, is also degraded.

The effect of degrading the frequency settling time is reduced by the block diagram as illustrated in Fig. 2b, where the closed-loop transfer function can be written as:

$$Y(s) = \frac{\alpha_{PD} \cdot H_{LF}(s) \cdot H_{DCO}(s)}{1 + \alpha_{PD} \cdot H_{LF}(s) \cdot H_{DCO}(s) + \mathbf{H_C(s)}} X(s)$$

$$+ \frac{H_{LF}(s) \cdot H_{DCO}(s)}{1 + \alpha_{PD} \cdot H_{LF}(s) \cdot H_{DCO}(s) + \mathbf{H_C(s)}} E(s),$$

(2)

where:

Hc(s) denotes the transfer function of the compensating filter element, in particular of an analog filter element in the forward path, where the analog filter output is fed back;

The remaining corresponds to the definitions for equation (1).

In the context of Eq. 2 $|H_c(s)|$ needs to be large against the other terms in the denominator of (2) in order to suppress the error signal E(s) effectively, i.e. $H_c(s)$ must contain peaking resonances that can both alter the poles of the PLL transfer function and lead to instability as well.

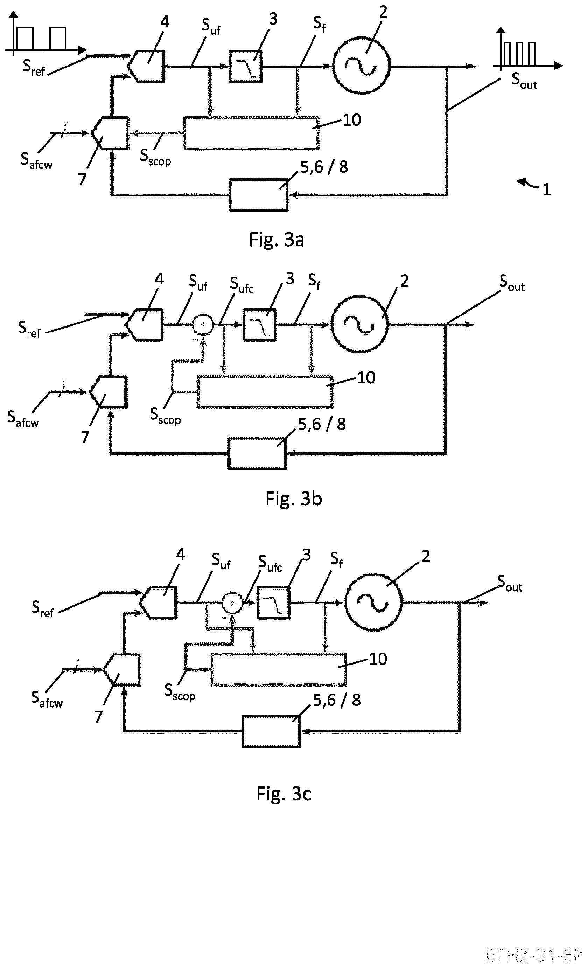

The disadvantages outlined before for the solutions known from the prior art are omitted by the example implementation of the digital PLL according to the invention as illustrated in Figs. 3a to 3c. In the following, the basic configuration of the digital PLL of Fig. 1a or Fig. 1b is assumed as the basis for further explanation.

It can be noticed in Fig. 3a that the digital-to-time converter 7 is situated in the feedback path but can be alternatively situated in the forward path receiving the reference AC signal $S_{ref}$. The frequency divider 5 and the delta-sigma modulator 6 are illustrated in one single block, situated in the feedback path. Alternatively, and considering Fig. 1b, the feedback element 5 corresponds to the re-timer circuit. The digital PLL now comprises the spur compensation unit 10, configured as a time-interleaved integrator, having two inputs. The first input is coupled to the connection line, which carries the unfiltered phase detector output signal $S_{uf}$ and the second input is connected to the connection line between the output of the loop filter 3 and the input of the digitally controlled oscillator 2, whereby the connection line carries the filtered phase detector output signal Sf. In simple terms, the spur compensation unit 10 takes the two input signals, each carrying an error signal of mutually different amplitudes, that would be noticeable as spurs in the output AC signal $S_{out}$ of the digital PLL when uncompensated. The spur compensation unit 10 inputs the two error signals, and determines a spur compensation signal $S_{comp}$ which can compensate for the error, thereby suppressing the spurs noticeable in the output AC signal $S_{out}$. The spur compensation signal $S_{comp}$ is inputted by the digital-to-time converter 7, which can be used for calibrating the digital-to-time converter 7, or as an addition to fractional part of the accumulated frequency control word signal $S_{afcw}$ input by the of the digital-to-time converter 7. In any case, the spur compensation signal $S_{comp}$ enables the digital-to-time converter 7 to operate linearly as desired under all operational scenarios.

Fig. 3b illustrates a different example of the application of the spur compensation unit 10 in the digital PLL of Fig. 1a or Fig. 1b, in which the spur compensation unit 10 is also configured as a time-interleaved integrator, but the spur compensation signal $S_{comp}$ is directly injected into the unfiltered phase detector output signal $S_{uf}$, and thereby directly suppressing the error signal. The spur compensation signal $S_{comp}$ is fed through a summing point situated between the output of the time-to-digital converter 4 and the tap point where the unfiltered phase detector output signal $S_{uf}$ for the spur compensation unit 10 is tapped. Fig. 3c illustrates a further variant, in which spur compensation signal $S_{comp}$ is fed through a summing point situated between the tap point where the unfiltered phase detector output signal $S_{uf}$ for the spur compensation unit 10 is tapped and the input of the digital loop filter 3. The spur compensation unit 10 is configured in this example as a time-interleaved low-pass filter.

The example implementation of the digital PLL illustrated in Figs. 3a-3c provide multiple advantages over the solution known from the prior art, in particular over the use of filter elements as illustrated in Figs. 2a and 2b. The common advantages of the PLLs in Figs. 3a-3c are that they take the loop dynamics into account by having an additional feedback path from the input to the digitally controlled oscillator 2, which is not the case for the implementations of Figs. 2a, 2b. With the proper design of the compensation functions provided by the two feedback paths, the original transfer function of the digital PLL can be maintained when the calibration is enabled, which is key to letting it run online in the background. So the issue of potential instability can be avoided. Furthermore, with appropriate design of the feedback paths, the error transfer function has zeros at the fractional grid defined by the number of channels of the time-interleaved compensation filter, which is not the case with the simpler loops of Figs. 2a, 2b. These zeros completely eliminate fractional spurs at the corresponding frequencies, which the simpler circuits cannot achieve.

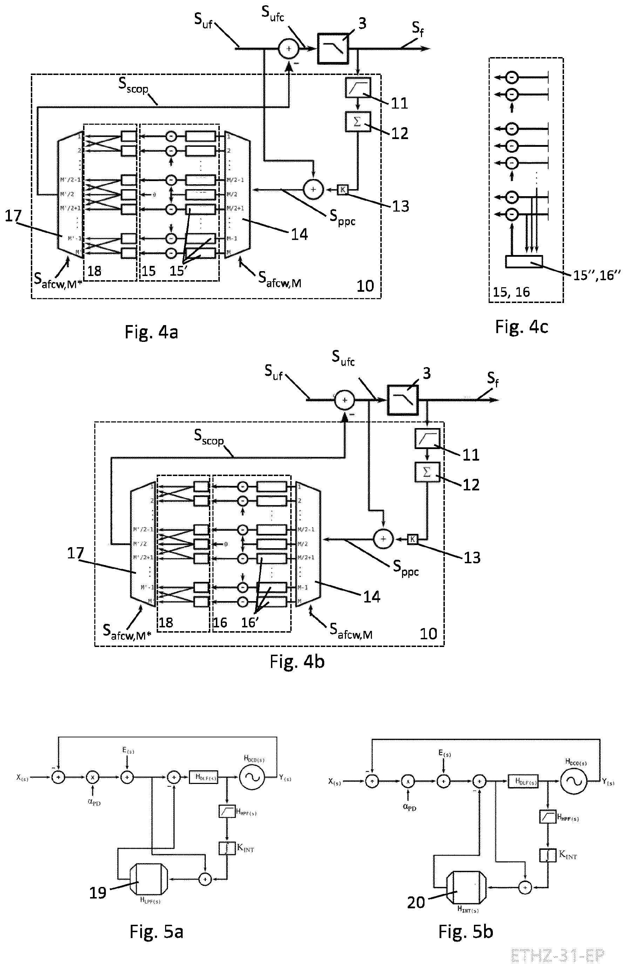

Figs. 4a-4c show variants of the spur compensation unit 10 in greater detail. The spur compensation unit 10 illustrated in Fig. 4a is used in the example of Fig. 3c. The filtered phase detector output signal St, is inputted into the spur compensation unit 10 and fed through the high-pass filter 11, the integrator 12 and proportionally adjusted with the use of the gain 13. The unfiltered uncorrected phase detector output signal $S_{ufc}$ is also inputted into the spur compensation unit 10 and added to the signal outputted by the gain 13 for forming the pre-processed control signal $S_{ppc}$. The high-pass filter 11 removes the DC component contained in the filtered phase detector output signal $S_f$. The pre-processed control signal $S_{ppc}$ is inputted into the demultiplexer 14, whereas the demultiplexer selectively outputs the pre-processed control signal $S_{ppc}$ to a different demultiplexer output, in dependency on the fractional part of the accumulated frequency control word signal $S_{afcw,M}$. As explained herein before, the digital PLL operates periodically in the fractional phase, for example, if the fractional part of the frequency control word $S_{fcw}$ corresponds to $frac(S_{fcw})=i/M$ ($i=\{1,2, ..., M-1\}$), the digital PLL will operate periodically on the M fractional phases with frequency $i*F_{ref}/M$. Therefore, the idea is to compensate for the non-idealities on M different points along the fractional phase instances. M is usually chosen as $M=2^B$ (B being an integer value), where B is typically smaller than the number of fractional bits of the frequency control word signal $S_{fcw}$.

The signals outputted at the demultiplexer outputs are inputted into the time-interleaved low-pass filters 15' each configured with an inband gain of one followed by the midpoint pinning stage 15.As the pre-processed control signal $S_{ppc}$ can include a DC offset, which is then also inputted into the related low-pass filter 15', this DC offset is eliminated by subtraction of the low pass filter 15' output at the position M/2 (midpoint) from all the other low pass filter outputs.. As said before, the low-pass filters 15' operate in parallel in a time-interleaved manner at a rate of $F_{ref}/M$ (when $frac(FCW)=i/M$), whereby $F_{ref}$ denotes the frequency of the reference signal $S_{ref}$.

The midpoint pinning stage 15 outputs the DC-freed signals (originating from each low-pass filter 15'), whereby the interpolation / extrapolation unit 18 inputs the DC-freed signals and stores the related signals in the cells (illustrated as a plurality of rectangles). Depending on the value of the accumulated fractional code word the interpolation / extrapolation unit 18 selects an individual input of the multiplexer 17, to which an interpolated / extrapolated value depending on the fractional bits not covered by the time-interleaved filter from the neighboring DC-freed signals stored in the cell is outputted. However, the interpolation / extrapolation unit 18 can be optional and might improve the reduction of spurs, as it can increase the number of correction points. When the interpolation / extrapolation unit 18 is omitted, the DC-freed signals are directly fed to individual inputs of the multiplexer 17 without using the interpolation / extrapolation unit 18. The order of the midpoint pinning stage 15 and the interpolation / extrapolation unit 18 can also be swapped, whereby this may come with additional computational efforts. The multiplexer 17 selects one of the inputs in dependency to the fractional part of the accumulated frequency control word signal $S_{afcw,M*}$. The output signal supplied by the multiplexer 17, which relates to the spur compensation signal $S_{scop}$, is then injected into the unfiltered phase detector output signal $S_{uf}$ and the periodic error contained is suppressed or at least significantly reduced.

The spur compensation unit 10 illustrated in Fig. 4b is used in the example of Fig. 3b. The spur compensation unit of Fig. 4b is configured equally as the said compensation unit of Fig. 4a, thereby providing the same functionality. The difference is that the midpoint pinning stage follows a plurality of integrators 16' instead of low pass filters 15'. Also, the integrators can be configured equally, partly equal or mutually different with respect to their summation capabilities. The equal configuration is preferred, due to low complexity. In addition, the present example differs in that the output signal supplied by the multiplexer 17, which relates to the spur compensation signal $S_{scop}$ is injected into the unfiltered phase detector output signal $S_{uf}$ at a different position.

Fig. 4c illustrates an alternative to the midpoint pinning stage 15, 16 used in Figs. 4a, 4b. Instead of referencing each output of the low-pass filter or integrator to a defined reference, the output signals of the low-pass filters or the integrators are inputted into the averaging stage 15",16" for determining an average, whereby the determined average is then subtracted from each output signal individually. By doing so, the DC offset mentioned before, is eliminated, and the midpoint pinning stage output signal contains a DC-free error signal. By using the method of Fig. 4c the midpoint pinning is obsolete, and the output at position M/2 also contains a signal that is processed the same way as all other signals of the array M.

Figs. 5a, 5b illustrate block diagrams of the digital PLL configured with a spur compensation unit, including a non-ideality injected into the PLL loop. The closed-loop transfer function of the in Figs. 5a illustrated block diagram can be represented in s-domain as:

$$Y(s) = \frac{\alpha_{PD} \cdot (1 - H_{LPF}(s)) \cdot H_{DLF}(s) \cdot H_{DCO}(s)}{1 + \alpha_{PD} \cdot (1 - H_{LPF}(s)) \cdot H_{DLF}(s) \cdot H_{DCO}(s) + H_{DLF}(s) \cdot {}^{K \cdot F_{ref}}/_s \cdot H_{LPF}(s) \cdot H_{HPF}(s)} X(s)$$

$$+ \frac{(1 - H_{LPF}(s)) \cdot H_{DLF}(s) \cdot H_{DCO}(s)}{1 + \alpha_{PD} \cdot (1 - H_{LPF}(s)) \cdot H_{DLF}(s) \cdot H_{DCO}(s) + H_{DLF}(s) \cdot {}^{K \cdot F_{ref}}/_s \cdot H_{LPF}(s) \cdot H_{HPF}(s)} E(s), \tag{3}$$

where:

$K \cdot {}^{F_{ref}}/_s$ denotes or represents the loop function and can be chosen to match $\alpha_{PD} \cdot H_{DCO}(s)$ in order to maintain the transfer function poles;

$H_{HPF(S)}$ denotes the transfer function of the high-pass filter of the spur compensation unit, which can e.g. be implemented as first order z-domain $H_{HPF(S)} = \frac{\alpha - \alpha z^{-1}}{1 - \alpha z^{-1}}$ with corner frequency below the first fractional spur frequency;

$H_{LPF(S)}$ denotes the transfer function time-interleaved low-pass filter comprised in the spur compensation unit, which can e.g. be implemented in z-domain as $H_{LPF}(z) = \frac{1 - \alpha}{1 - \alpha z^{-M}}$ given at an update rate of $F_{ref}/M$;

$H_{DLF(S)}$ denotes the transfer function of the digital loop filter (digital low-pass);

The remaining corresponds to the definitions for equation (1).

Equation (3) presents the situation for the digital PLL in the configuration of Fig. 3c in particular with the time-interleaved low-pass filter 19. It can be noticed that for frequencies not pertaining to spur frequencies, equation (3) simplifies to:

$$|H_{LPF}(s)| < -40\text{dB} \approx 0 \rightarrow Y(s) = \frac{\alpha_{PD} \cdot H_{DLF}(s) \cdot H_{DCO}(s)}{1 + \alpha_{PD} \cdot H_{DLF}(s) \cdot H_{DCO}(s)} X(s),$$

which is an indication that the loop function is not affected by the spur compensation unit. For frequencies higher than the bandwidth of the high-pass filter $H_{HPF}$ comprised in the spur compensation unit that are within the bandwidth of the low-pass filter $H_{LPF}$, equation (3) simplifies to:

$$|H_{LPF}(s)| \approx 1 \, , \, |H_{HPF}(s)| \approx 1 \blacktriangleright$$

$$Y(s) \approx \frac{(1-H_{LPF}(s))\alpha_{PD}\cdot H_{DLF}(s)\cdot H_{DCO}(s)}{1+\frac{K\cdot F_{ref}}{s}\cdot H_{DLF}(s)}X(s) + \frac{(1-H_{LPF}(s))H_{DLF}(s)\cdot H_{DCO}(s)}{1+\frac{K\cdot F_{ref}}{s}\cdot H_{DLF}(s)}E(s),$$

whereby spurs are reduced by the factor $|1 - H_{LPF}(s)|$, the stability of the loop is maintained, and the transfer function remains the same if $\frac{K\cdot F_{ref}}{s}$ is chosen as $\alpha_{PD} \cdot H_{DCO}(s)$.

The closed-loop transfer function of the in Figs. 5b illustrated block diagram can be presented as:

$$Y(s) =$$
$$\frac{\alpha_{PD} \cdot H_{DLF}(s) \cdot H_{DCO}(s)}{1 + \alpha_{PD} \cdot H_{DLF}(s) \cdot H_{DCO}(s) + H_{INT}(s)(1 + H_{DLF}(s) \cdot \frac{K\cdot F_{ref}}{s} \cdot H_{HPF}(s))}X(s) \qquad (4)$$
$$+ \frac{H_{DLF}(s) \cdot H_{DCO}(s)}{1 + \alpha_{PD} \cdot H_{DLF}(s) \cdot H_{DCO}(s) + H_{INT}(s)(1 + H_{DLF}(s) \cdot \frac{K\cdot F_{ref}}{s} \cdot H_{HPF}(s))}E(s),$$

where:

$\frac{K\cdot F_{ref}}{s}$ denotes or represents the loop function and can be chosen to match $\alpha_{PD} \cdot H_{DCO}(s)$ in order to maintain the transfer function poles;

$H_{HPF(S)}$ denotes the transfer function of the high-pass filter of the spur compensation unit, which can e.g. be implemented as first order $H_{HPF(S)}=\frac{\alpha-\alpha z^{-1}}{1-\alpha z^{-1}}$ with corner frequency below the first fractional spur frequency;

$H_{LPF(S)}$ denotes the transfer function time-interleaved low-pass filter comprised in the spur compensation unit, which can e.g. be implemented in z-domain as $H_{LPF}(z) = \frac{1-\alpha}{1-\alpha z^{-M}}$ given at an update rate of $F_{ref}/M$;

$H_{DLF(S)}$ denotes the transfer function of the digital loop filter (digital low-pass);

The remaining corresponds to the definitions for equation (1).

Equation (4) presents the situation for the digital PLL in the configuration of Fig. 3b, in particular with the time-interleaved integrator 20. It can be noticed that for frequencies not pertaining to spur frequencies, equation (4) simplifies to:

$$|H_{INT}(s)| < -40dB \approx 0 \blacktriangleright Y(s) = \frac{\alpha_{PD}\cdot H_{DLF}(s)\cdot H_{DCO}(s)}{1+\alpha_{PD}\cdot H_{DLF}(s)\cdot H_{DCO}(s)}X(s),$$

which is an indication that the loop function is not affected by the spur compensation unit. For frequencies higher than the bandwidth of the high-pass filter comprised in the spur compensation unit and that are close to the fractional spur frequencies, equation (4) can be approximated as:

$$|H_{INT}(s)| \gg 1 \, , \, |H_{HPF}(s)| \approx 1 \blacktriangleright$$

$$Y(s) \approx \frac{\alpha_{PD}\cdot H_{DLF}(s)\cdot H_{DCO}(s)}{H_{INT}(s)\cdot\left(1+\frac{K\cdot F_{ref}}{s}\cdot H_{DLF}(s)\right)}X(s) + \frac{H_{DLF}(s)\cdot H_{DCO}(s)}{H_{INT}(s)\cdot\left(1+\frac{K\cdot F_{ref}}{s}\cdot H_{DLF}(s)\right)}E(s),$$

whereby spurs are reduced by the factor $1/|H_{INT}(s)|$, and the stability of the loop is maintained.

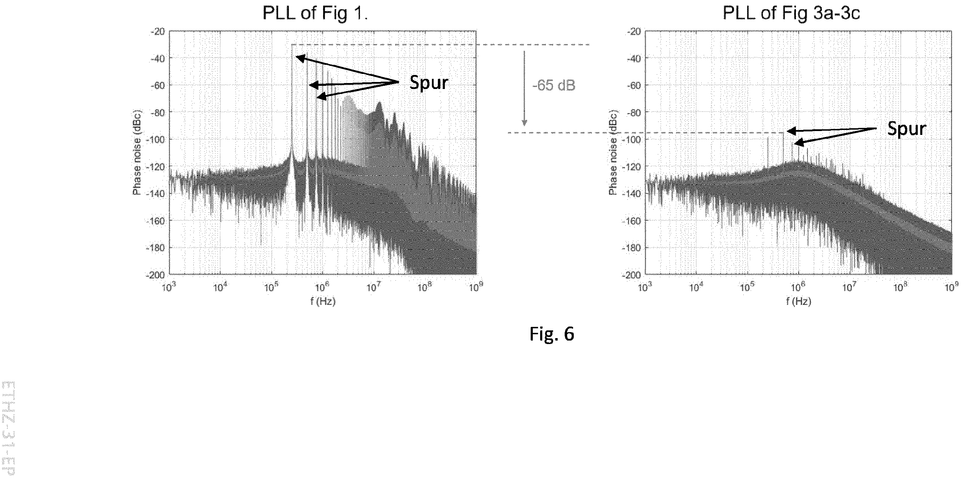

Fig. 6 shows example simulation results of the noise floor of the digital PLL of Fig. 1b on the left and the digital PLL in every configuration illustrated in Figs. 3a-3c on the right. In both graphs, the phase noise (ordinate) over the frequency (abscissa) is illustrated, whereby the phase noise was measured in dB relative to the carrier. The slope error for both scenarios accounted for 5%, whereas a ramp of second-order with a nonlinearity 10% was injected into the unfiltered phase detector output signal for simulating non-idealities that can occur during common operational scenarios. The frequency control word signal accounted in both scenarios to the integer part 50 and the fractional part 1/256.

It can be noticed on the left that the signal comprises multiple spurs, whereas the most dominant spur is located at 250 kHz with an amplitude of -16.2 dB relative to the carrier. The digital PLL comprising the spur compensation unit provides a more even spectrum, and the spur with the highest level is located at 500 kHz with an amplitude of -81.1 dB relative to the carrier. In summary, the spur compensation unit can achieve, under this ambitious scenario, a spur reduction of approximately -65 dB relative to the carrier.

**Reference symbols in the figures**

| | |
|---|---|
| 1 | Digital fractional-N frequency synthesizer, digital fractional-N PLL |
| 2 | Digitally controlled oscillator (DCO) |
| 3 | Low-pass filter (digital, loop) |
| 4 | Time-to-digital converter (digital phase detector) |
| 5 | Feedback element (e.g. digital frequency divider) |
| 6 | Delta-Sigma Modulator |
| 7 | Digital-to-time converter |
| 8 | Re-timer circuit |
| 9 | Frequency-locked-loop |
| 10 | Spur compensation unit |
| 11 | High-pass filter (digital, spur compensation unit) |
| 12 | Integrator (digital, spur compensation unit) |
| 13 | Gain (digital, spur compensation unit) |
| 14 | Demultiplexer |
| 15, 16 | Midpoint pinning |
| 15' | Low-pass filter (digital, spur compensation unit) |
| 16' | Integrator(digital, midpoint pinning) |
| 15", 16" | Averaging (digital, midpoint pinning) |
| 17 | Multiplexer |
| 18 | Interpolation/extrapolation unit |
| 19 | Time-interleaved low-pass filter (digital, spur compensation unit) |
| 20 | Time-interleaved integrator (digital, spur compensation unit) |
| $E(s)$ | Non-ideality, disturbance |
| $H_c(s)$ | Transfer function filter element |
| $H_{DCO(S)}$ | Transfer function DCO |
| $H_{INT(S)}$ | Transfer function integrator (digital, spur compensation unit) |
| $H_{LF(S)}$, $H_{DLF(S)}$ | Transfer function low-pass filter (digital, loop) |
| $H_{HPF(S)}$ | Transfer function high-pass filter (digital, spur compensation unit) |
| St | Filtered phase detector output signal |
| $S_{fcw}$ | Frequency control word signal |
| $S_{fcw,F}$ | Fractional part of frequency control word signal |
| $S_{few,I}$ | Integer part of Frequency control word signal |
| $S_{afcw}$ | Fractional part of the accumulated frequency control word signal |
| $S_{afcw,M}$ | Fractional part of the accumulated frequency control word signal (highest B bits, M=2^B) |
| $S_{out}$ | Output AC signal |
| $S_{ppc}$ | Pre-processed control signal |
| $S_{ref}$ | Reference AC signal |
| $S_{scop}$ | Spur compensation signal |
| $S_{uf}$ | Unfiltered phase detector output signal |
| $S_{ufc}$ | Unfiltered corrected phase detector output signal |
| $X(s)$ | Input phase |
| $Y(s)$ | Output |
| $\alpha_{PD}$ | Proportional signal digital phase detector |

Claims

1. A digital fractional-N phase lock loop (PLL) (1), comprising:

- a forward path comprising a phase detector (4), a digital loop filter (3), a digitally-controlled oscillator (2);
- a feedback path comprising a feedback element (5, 6), wherein a phase detector output of the phase detector (4) is connected to a loop filter input of the digital loop filter (3) for providing an unfiltered control signal ($S_{uf}$), and a loop filter output of the digital loop filter (3) is connected to an oscillator input of the digitally-controlled oscillator (2) for providing a filtered control signal (Sf), wherein the unfiltered control signal ($S_{uf}$) and the filtered control signal (Sf) each contain a periodic error signal having a mutually different amplitude;
- a digital-to-time converter (7), arranged in the forward or the feedback path and connected with a converter output to a phase detector input of the phase detector (4);
- a spur compensation unit (10) arranged with two inputs and an output, wherein a first input is provided to receive the unfiltered control signal ($S_{uf}$) and a second input is configured to receive the filtered control signal (Sf), wherein the spur compensation unit (10) is provided to determine a compensation signal ($S_{scop}$) along a fractional phase instance of operation of the digital fractional-N PLL (1), and wherein the spur compensation unit (10) is further arranged to output the said compensation signal ($S_{scop}$) to a converter input of the digital-to-time converter (7) or wherein the spur compensation unit (10) is further provided to inject the said compensation signal ($S_{scop}$) into the unfiltered control signal ($S_{uf}$) for compensating the periodic error signal.

2. The digital fractional-N PLL (1) of claim 1, the feedback element (5, 6) is configured as a fractional divider or a re-timer circuit and wherein the phase detector (4) is provided as a time-to-digital converter, preferably as a multi- or single bit time-to-digital converter.

3. The digital fractional-N PLL (1) of claim 1 or 2, the spur compensation unit (10) comprises a pre-processing stage (11, 12, 13), configured with a digital high-pass filter (11), a digital integrator (12) and a proportional gain (13) arranged in series, wherein the spur compensation unit (10) being adapted to pass the filtered control signal (Sf) through the pre-processing stage (11, 12, 13) and is provided to sum the passed filtered control signal with the unfiltered control signal ($S_{uf}$) by means of an adder for providing a pre-processed control signal ($S_{ppc}$) at a pre-processing stage output.

4. The digital fractional-N PLL (1) of claim 3, the spur compensation unit (10) further comprises a time-interleaved low-pass filter (19) configured with a low-pass filter input and output, wherein the low-pass filter input is connected to the pre-processing stage output and the low-pass filter output is engaged with the connection between the phase detector output and the loop filter input to inject the said compensation signal ($S_{scop}$) into the unfiltered control signal ($S_{uf}$) for compensation the periodic error signal.

5. The digital fractional-N PLL (1) of claim 4, wherein the connection between the phase detector output and the loop filter input comprises an injection point for injecting the compensation signal ($S_{scop}$) into the unfiltered control signal ($S_{uf}$) and a tap point for connecting the first input of the spur compensation unit (10) to the connection, wherein the injection point is situated between the loop filter input and the tap point.

6. The digital fractional-N PLL (1) of claim 3, the spur compensation unit (10) further comprises a time-interleaved integrator (20) configured with an integrator input and an integrator output, wherein the integrator input is connected to the pre-processing stage output and the integrator output is engaged with the connection between the phase detector output and the loop filter input to inject the said compensation signal ($S_{scop}$) into the unfiltered control signal ($S_{uf}$) or the integrator output is connected to the converter input of the digital-to-time converter (7) for compensation the periodic error signal.

7. The digital fractional-N PLL (1) of claim 6, wherein the connection between the phase detector output and the loop filter input comprises an injection point for injecting the compensation signal ($S_{scop}$) into the unfiltered control signal ($S_{uf}$) and a tap point for connecting the first input of the spur compensation unit (10) to the connection, wherein the tap point is situated between the loop filter input and the injection point.

8. The digital fractional-N PLL (1) of anyone of the claims 4 to 7, the time-interleaved low-pass filter (19), or the time-interleaved integrator (20) comprises a demultiplexer stage (14) configured with two demultiplexer inputs and a number of demultiplexer outputs, wherein a first demultiplexer input is configured to receive the pre-processed control signal ($S_{ppc}$) and a second demultiplexer input is configured to receive a fractional part of an accumulated frequency control word signal ($S_{afcw,M}$), wherein the demultiplexer stage (14) is arranged to output the pre-processed control signal ($S_{ppc}$) to different demultiplexer outputs dependent on a value of the fractional part of the accumulated frequency control word signal ($S_{afcw,M}$).

9. The digital fractional-N PLL (1) of claim 8, the time-interleaved low-pass filter (19) comprises a midpoint pinning stage (15, 16) provided with a number of midpoint pinning stage outputs and configured with a number of low-pass filters (15'), wherein each low-pass filter (15') is connected at a low-pass filter input to one demultiplexer output.

10. The digital fractional-N PLL (1) of claim 8, the time-interleaved integrator (20) comprises a midpoint pinning stage (15, 16) provided with a number of midpoint pinning stage outputs and configured with a number of integrators (16'), wherein each integrator (16') is connected at an integrator input to one demultiplexer output.

11. The digital fractional-N PLL (1) of claim 9 or 10, wherein each low-pass filter (15') is configured with a low-pass filter output or wherein each integrator (16') is provided with an integrator output, wherein the midpoint pinning stage (15, 16) is provided to reference each low-pass filter output or each integrator output to a reference threshold for removing a DC signal component comprised pre-processed control signal ($S_{ppc}$).

12. The digital fractional-N PLL (1) of claim 9 or 10, the midpoint pinning stage (15, 16) comprises an averaging stage (15", 16") configured with a number of averaging stage inputs and an averaging stage output, wherein each averaging stage input is connected to a low-pass filter output or an integrator output, wherein the averaging stage (15", 16") is configured to determine an average from output signals outputted at the low-pass filter outputs or integrator outputs, wherein the averaging stage output is engaged with midpoint pinning stage outputs for subtracting the determined average from the output signals outputted at the low-pass filter outputs or integrator outputs.

13. The digital fractional-N PLL (1) of claim 11 or 12, the time-interleaved low-pass filter (19), or the time-interleaved integrator (20) comprises a multiplexer stage (17) configured with a number of multiplexer inputs and a multiplexer output, wherein each multiplexer input of a first number of multiplexer inputs is connected to a midpoint pinning stage output and wherein one multiplexer input of a second number of multiplexer inputs is configured to receive the accumulated frequency control word signal ($S_{afcw,M}$), wherein the multiplexer stage (17) is arranged to connect a different midpoint pinning stage output to the multiplexer output dependent on a value of the fractional part of the accumulated frequency control word signal ($S_{afcw,M}$) for providing the compensation signal ($S_{scop}$) at the multiplexer output.

14. The digital fractional-N PLL (1) of claim 11 or 12, the time-interleaved low-pass filter (19), or the time-interleaved integrator (20) comprises an interpolation/extrapolation unit (18) configured with a number of inputs and outputs, wherein each input is connected to a midpoint pinning stage output, wherein the time-interleaved low-pass filter (19) is configured to interpolate or extrapolate between signals outputted at the midpoint pinning stage outputs and held within the interpolation/extrapolation unit (18).

15. The digital fractional-N PLL (1) of claim 14, the time-interleaved low-pass filter (19), or the time-interleaved integrator (20) comprises a multiplexer stage (17) configured with a number of multiplexer inputs and a multiplexer output, wherein each multiplexer input of a first number of multiplexer inputs is connected to an output of the interpolation/extrapolation unit (18) and wherein one multiplexer input of a second number of multiplexer inputs is configured to receive the accumulated frequency control word signal ($S_{afcw,M}$), wherein the multiplexer stage (17) is arranged to connect a different output of the interpolation/extrapolation unit (18) to the multiplexer output dependent on a value of the fractional part of the accumulated frequency control word signal ($S_{afcw,M}$) for providing the compensation signal ($S_{scop}$) at the multiplexer output.

Fig. 1a (prior art)

Fig. 1b (prior art)

Fig. 2a (prior art)

Fig. 2b (prior art)

Fig. 3a

Fig. 3b

Fig. 3c

ETHZ-31-EP

16

Fig. 4a

Fig. 4c

Fig. 4b

Fig. 5a

Fig. 5b

Fig. 6

Europäisches
Patentamt

European
Patent Office

Office européen
des brevets

# EUROPEAN SEARCH REPORT

Application Number

**EP 23 17 6446**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MERCANDELLI MARIO ET AL: "A Background Calibration Technique to Control the Bandwidth of Digital PLLs", IEEE JOURNAL OF SOLID-STATE CIRCUITS, IEEE, USA, vol. 53, no. 11, 1 November 2018 (2018-11-01), pages 3243-3255, XP011693759, ISSN: 0018-9200, DOI: 10.1109/JSSC.2018.2866454 [retrieved on 2018-10-30] | 1,2 | INV. H03L7/093 H03L7/197 |
| A | * paragraph [000I] – paragraph [0VII]; figures 1-22 * | 3-15 | |
| A | LEVANTINO SALVATORE ET AL: "Nonlinearity cancellation in digital PLLs (Invited paper)", PROCEEDINGS OF THE IEEE 2013 CUSTOM INTEGRATED CIRCUITS CONFERENCE, IEEE, 22 September 2013 (2013-09-22), pages 1-8, XP032524737, DOI: 10.1109/CICC.2013.6658472 [retrieved on 2013-11-07] * paragraph [000I] – paragraph [00VI]; figures 1-13 * | 1-15 | |

TECHNICAL FIELDS SEARCHED (IPC)

H03L

-/--

The present search report has been drawn up for all claims

| Place of search | Date of completion of the search | Examiner |
|---|---|---|
| The Hague | 10 November 2023 | Rafflenbeul, A |

EPO FORM 1503 03.82 (P04C01)

**EUROPEAN SEARCH REPORT**

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SEONG TAEHO ET AL: "17.3 A -58dBc-Worst-Fractional-Spur and -234dB-FoMjitter, 5.5GHz Ring-DCO-Based Fractional-N DPLL Using a Time-Invariant-Probability Modulator, Generating a Nonlinearity-Robust DTC-Control Word", 2020 IEEE INTERNATIONAL SOLID- STATE CIRCUITS CONFERENCE - (ISSCC), IEEE, 16 February 2020 (2020-02-16), pages 270-272, XP033754375, DOI: 10.1109/ISSCC19947.2020.9062948 [retrieved on 2020-04-09] * page 270; figures 1-S2 * | 1-15 | |
| A | US 10 819 353 B1 (MONK TIMOTHY A [US] ET AL) 27 October 2020 (2020-10-27) * column 1 – column 10; figures 1-9 * | 1-15 | |
| A | US 2018/241404 A1 (BU LONG [US] ET AL) 23 August 2018 (2018-08-23) * paragraph [0002] – paragraph [0025]; figures 1-3 * | 1-15 | TECHNICAL FIELDS SEARCHED (IPC) |

The present search report has been drawn up for all claims

| Place of search | Date of completion of the search | Examiner |
|---|---|---|
| The Hague | 10 November 2023 | Rafflenbeul, A |

EPO FORM 1503 03.82 (P04C01)

## ANNEX TO THE EUROPEAN SEARCH REPORT
## ON EUROPEAN PATENT APPLICATION NO.

EP 23 17 6446

This annex lists the patent family members relating to the patent documents cited in  the above-mentioned European search report.
The members are as contained in the European Patent Office EDP file on
The European Patent Office is in no way liable for these particulars which are merely given for the purpose of information.

10-11-2023

| Patent document cited in search report | | Publication date | Patent family member(s) | Publication date |
|---|---|---|---|---|
| US 10819353 | B1 | 27-10-2020 | NONE | |
| US 2018241404 | A1 | 23-08-2018 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P. CHEN et al.** Fractional Spur Suppression in All-Digital Phase-Locked Loops. *2015 IEEE International Symposium on Circuits and Systems (ISCAS),* May 2015